# EUROPÄISCHE PATENTSCHRIFT

(11) **EP 1 857 878 B1**
(45) Veröffentlichungstag und Bekanntmachung des Hinweises auf die Patenterteilung: **20.01.2010**
(21) Anmeldenummer: 06010461.9
(22) Anmeldetag: 20.05.2006
(51) Int. Cl.: G03F 7/20, F16F 15/023, F16F 15/027

(54) **Aktives Schwingungsisolationssystem mit einem kombinierten Positionsaktor**
Active vibration isolating system with combined position actuator
Système actif d'amortissement de vibrations avec actionneur de position combiné

(43) Veröffentlichungstag der Anmeldung: 21.11.2007
(73) Patentinhaber: Integrated Dynamics Engineering GmbH, 65479 Raunheim (DE)
(72) Erfinder: Heiland, Peter, 65479 Raunheim (DE)
(74) Vertreter: Herden, Andreas F.

(56) Entgegenhaltungen:
- US-A- 5 285 995
- US-A- 6 036 162
- US-B1- 6 202 492
- US-B1- 6 523 695

## Beschreibung

### Gebiet der Erfindung

Die Erfindung betrifft ein aktives Schwingungsisolationssystem, insbesondere ein Schwingungsisolationssystem mit Luftlagern.

### Hintergrund der Erfindung

Schwingungsisolationssysteme sind bekannt. So zeigt beispielsweise die EP 927 380 Bl ein Schwingungsisolationssystem mit Luftlagern, welches insbesondere der Lagerung eines Lithographiegerätes dient. Die US 6,523,695 zeigt ein Verfahren zur Schwingungsisolation mit einer Feedback-Schleife, welche einen Drucksensor in einem Luftlager umfasst. Die US 6,202,492 zeigt eine Vorrichtung zur Schwingungsisolation, die sowohl Aktoren als auch Luftlager umfasst, die über einen Controller angesteuert werden.

Derartige Schwingungsisolationssysteme werden in vielen weiteren Bereichen der Technik eingesetzt. Insbesondere in der Halbleiterindustrie steigen mit weiter fortschreitender Miniaturisierung die Anforderungen an Schwingungsisolationssysteme, auf denen beispielsweise Fertigungsanlagen gelagert sind.

Schwingungsisolationssysteme mit Luftlagern können eine aktive Steuerung aufweisen, bei welcher ein oder mehrere Positionssensoren die Position der zu lagernden Last erfassen und über die Erfassung der Position die Druckluftzufuhr zu den Luftlagern geregelt wird. Wird das Schwingungsisolationssystem mit einer schwereren Last belastet, wird durch eine derartige aktive Regelung automatisch der Luftdruck erhöht und so ein Niveauausgleich geschaffen.

Die Regelschleife, die diesen Niveauausgleich bereitstellt, ist aufgrund der pneumatischen Ventile, die relativ träge ansprechen und aufgrund des großen Luftvolumens im System relativ langsam und erreicht in der Regel eine Regelbandbreite von weniger als 3 Hz. Schwingungen höherer Frequenz kann durch diese Regelschleife daher nicht effektiv entgegengewirkt werden. Vielmehr ist im Wesentlichen lediglich ein Niveauausgleich möglich.

Um schnellere Positionsänderungen, beispielsweise durch Schwingungen aufgrund von Resonanzen, reduzieren zu können, gibt es Schwingungsisolationssysteme, die zusätzlich zu der Regelung der Druckluftzufuhr Aktoren aufweisen, welche berührungslos an der zu isolierenden Last angreifen und über eine weitere Regelschleife betrieben werden.

Für derartige Aktoren, welche als Magnet- oder Piezo-Aktoren ausgestaltet sein können, erreichen die entsprechenden Regelschleifen Regelbandbreiten mit Frequenzen von über 200 Hz. Nachteilig hat sich gezeigt, dass diese Aktoren einen hohen Stromverbrauch haben und, da sie unabhängig von der pneumatischen Regelung arbeiten, häufig entgegengesetzt der Pneumatikregelung arbeiten.

### Aufgabe der Erfindung

Der Erfindung liegt demgegenüber die Aufgabe zugrunde, das Zusammenwirken der Regelschleife des Fluiddrucks mit der Regelschleife der Aktoren zu verbessern.

Insbesondere ist Aufgabe der Erfindung, den Stromverbrauch der Aktoren zu reduzieren.

Weiter ist Aufgabe der Erfindung, die Isolationswirkung eines Schwingungsisolationssystems weiter zu verbessern.

### Zusammenfassung der Erfindung

Die Aufgabe der Erfindung wird bereits durch ein Schwingungsisolationssystem sowie durch ein Verfahren zur Schwingungsisolation nach einem der unabhängigen Ansprüche erreicht.

Bevorzugte Ausführungsformen und Weiterbildung der Erfindung sind den jeweiligen Unteransprüchen zu entnehmen.

Danach ist ein Schwingungsisolationssystem vorgesehen, welches zumindest ein Fluidlager mit einer ersten Regeleinrichtung zur Steuerung des Fluiddrucks und einen Aktor zum aktiven Ausgleichen von Positionsänderungen der zu isolierenden Last umfasst, wobei der Aktor von einer zweiten Regeleinrichtung gesteuert wird.

Die erste und die zweite Regeleinrichtung sind dabei mit zumindest einem Sensor verbunden, welcher die Position der zu lagernden Last erfasst.

Gemäß der Erfindung ist ein Eingang einer Regeleinrichtung mit dem Ausgang der anderen Regeleinrichtung verbunden. Die Regeleinrichtungen sind also kaskadisch geschaltet. Dies führt dazu, dass die beiden Regelschleifen aufeinander abgestimmt arbeiten. So wird insbesondere der Stromverbrauch der Aktoren reduziert.

Im Sinne der Erfindung ist nicht zwingend vorgesehen, dass es sich bei den Regeleinrichtungen um räumlich und/oder schaltungstechnisch getrennte Anordnungen handelt, vielmehr können die beiden Regeleinrichtungen auch in einem einzigen Bauteil vereint sein, beispielsweise kann ein Computer die Steuerung sowohl der Fluidlager als auch der Aktoren übernehmen. Die erfindungsgemäße Regelung kann so auch rein softwarebasiert erfolgen und ist dementsprechend ohne großen Aufwand nachrüstbar.

Gemäß der Erfindung ist der Eingang der ersten Regeleinrichtung, also der Regeleinrichtung des Fluiddrucks mit dem Ausgang der zweiten Regeleinrichtung, der Regeleinrichtung des Aktors verbunden. So wird erreicht, dass das Steuersignal für den Kraftaktor mittels der Fluidregelung gegen Null geregelt wird. Die langsamere Fluidregelschleife übernimmt bei langsamen Bewegungen die Positionsregelung des Aktors. Nur zur Kompensation von schnellen Positionsänderungen ist ein Eingreifen der Aktoren erforderlich.

Der Eingang der zweiten Regeleinrichtung ist mit zumindest einem Positionssensor, der die Lager der zu isolierenden Last in zumindest einer Raumrichtung erfasst, verbunden. Vorzugsweise werden Sensoren verwendet, welche Positionsänderungen in alle drei Raumrichtungen erfassen.

Das Fluidlager ist vorzugsweise als Luftlager ausgebildet. Das Schwingungsisolationssystem weist vorzugsweise zumindest drei derartige Luftlager auf, so dass eine zu lagernde Last vollständig auf Luftlagern gelagert ist.

Als Aktoren werden vorzugsweise Magnet-Aktoren, insbesondere Tauchspulen mit einem Permanentmagneten oder Piezo-Aktoren verwendet. Mit derartigen Aktoren kann berührungslos an der zu lagernden Last angegriffen werden. Es wird so vermieden, dass durch die Aktoren Schwingungen, insbesondere hochfrequente Schwingungen, in das System eingekoppelt werden.

Die Regeleinrichtung des oder der Fluidlager arbeitet mit einer Regelbandbreite mit einem niedrigen Frequenzbereich, vorzugsweise reicht die Regelbandbreite nicht über 20 Hz, bevorzugt über 10 Hz und besonders bevorzugt über 5 Hz.

Die Bandbreite der zweiten Regeleinrichtung erfasst, dagegen auch höhere Frequenzen, insbesondere Schwingungen, die durch Resonanzfrequenzen des Gebäudes oder von Bauteilen des Schwingungsisolationssystems verursacht werden. Dabei sind Regelbandbreiten möglich, welche Frequenzen über 50 Hz, bevorzugt über 100 Hz und besonders bevorzugt sogar über 200 Hz umfassen.

Der Fluiddruck wird vorzugsweise über ein elektropneumatisches Ventil gesteuert. Ein derartiges Ventil lässt sich leicht ansteuern. Vorzugsweise werden Ventile verwendet, welche im Wesentlichen hystereseschleifenfrei arbeiten.

Die Erfindung betrifft des Weiteren ein Verfahren zu Schwingungsisolation, bei welchem eine zu isolierende Last auf Fluidlagern gelagert und der Fluiddruck der Lager über zumindest eine Regeleinrichtung gesteuert wird, welche mit einem Sensor zur Positionserfassung der zu isolierenden Last verbunden ist. Es wird also zunächst über die erste Regeleinrichtung eine Art Niveauausgleich bereitgestellt.

Weiter wird über zumindest einen Aktor, welcher über eine zweite Regeleinrichtung gesteuert wird, eine zusätzliche aktive Schwingungsisolation bereitgestellt, welche insbesondere höherfrequente Schwingungen reduziert.

Gemäß der Erfindung wird das Ausgangssignal einer Regeleinrichtung als Eingangssignal an die andere Regeleinrichtung weitergeleitet. Die Regeleinrichtungen sind somit kaskadiert geschaltet.

Das Ausgangssignal der zweiten Regeleinrichtung, also der Regeleinrichtung des oder der Aktoren, wird als Eingangssignal an die erste Regeleinrichtung weitergegeben. Durch diese kaskadierte Schaltung wird das Steuersignal für die Aktoren durch die Fluidregelung in Richtung Null geregelt.

Es versteht sich, dass unter dem Ausgangssignal nicht zwangsläufig genau das Signal verstanden wird, welches als beispielsweise Spannungssignal die Aktoren steuert.

Vielmehr kann es sich auch um Signale handeln, welche mit diesem Signal in einer mathematisch festen Beziehung stehen. Beispielsweise kann es sinnvoll sein, das Spannungssignal für die Kraftaktoren vor der Weitergabe an die Regeleinrichtung für die Fluidregelung zu reduzieren, etwa durch einen Spannungsteiler, da eine Regeleinrichtung mit einer niedrigeren Spannung betrieben wird.

Der Fluiddruck wird vorzugsweise mit einer geringeren Regelbandbreite gesteuert als der oder die Aktoren. So läuft die Regelung des Fluiddrucks der Aktorenregelung hinterher und regelt für langsame Schwingungen das Steuersignal für die Aktoren auf Null. Die Aktoren greifen also nur ein, um Schwingungen zu reduzieren, welche durch die langsame Regelung des Fluiddrucks nicht abgefangen werden können.

### Beschreibung der Zeichnungen

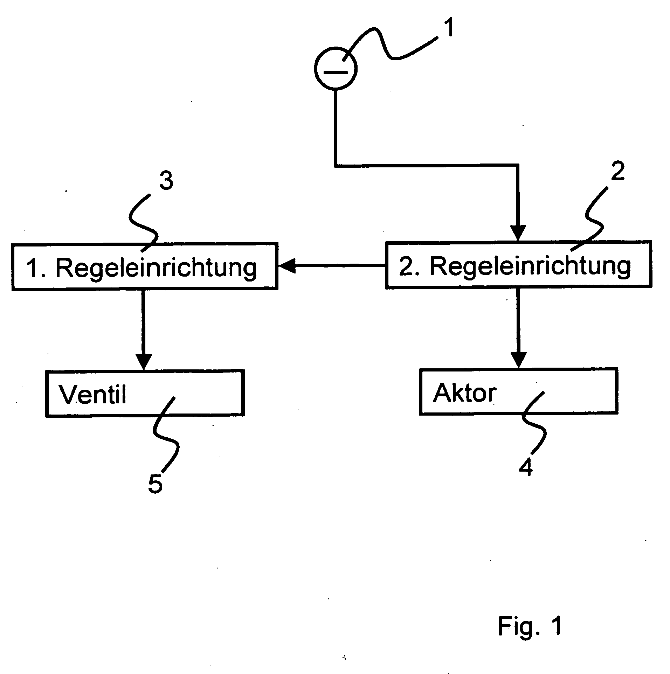

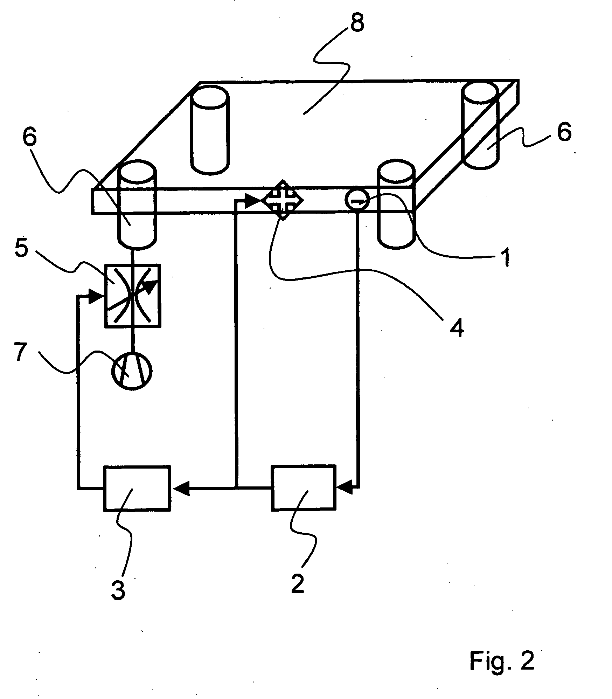

Die Erfindung soll im Folgenden anhand der Figuren Fig. 1 und Fig. 2 näher erläutert werden.
- Fig. 1: zeigt schematisch ein Blockschaltbild der wesentlichen Bestandteile eines erfindungsgemäßen Schwingungsisolationssystems,
- Fig. 2: zeigt schematisch ein Ausführungsbeispiel eines Schwingungsisolationssystems.

### Detaillierte Beschreibung der Zeichnungen

Das Blockschaltbild gemäß Fig. 1 zeigt schematisch das Zusammenwirken der verschiedenen Komponenten eines erfindungsgemäßen Schwingungsisolationssystems. Das Schwingungsisolationssystem weist zumindest einen Positionssensor 1 auf, der die Lage einer zu isolierenden Last (nicht dargestellt) erfasst. Das Ausgangssignal des Positionssensors 1 wird an eine Regeleinrichtung zur Regelung der Aktoren, die zweite Regeleinrichtung 2, weitergegeben. Die zweite Regeleinrichtung 2 generiert ein Ausgangssignal, welches den oder die Aktoren 4 steuert.

Gleichzeitig wird ein Ausgangssignal der zweiten Regeleinrichtung 2 an die Regeleinrichtung zur Regelung des Fluiddrucks, die erste Regeleinrichtung 3, weitergegeben. Die erste Regeleinrichtung 3 verwendet so das Ausgangssignal der zweiten Regeleinrichtung 2 als Eingangssignal. Die Regeleinrichtungen 2, 3 sind kaskadiert geschaltet.

Über das Ausgangssignal der ersten Regeleinrichtung 3 wird das oder die Ventile 5 zur Regelung des Fluiddrucks gesteuert. So läuft die Regelung des Fluiddrucks der Regelung der Aktoren nach. Die Aktoren greifen nur ein, um Schwingungen zu reduzieren, welche durch die langsame Regelung des Fluiddrucks nicht abgefangen werden können. Tendenziell wird das Steuersignal für die Aktoren 4 über die Fluiddruckregelung gegen Null ausgeregelt.

Fig. 2 zeigt schematisch ein Schwingungsisolationssystem. Das Schwingungsisolationssystem umfasst eine Platte 8, auf welcher zu isolierende Gegenstände (nicht dargestellt) gelagert werden können. Die Platte 8 ist somit zugleich Teil der zu isolierenden Last. Die Platte 8 ist auf vier Luftlagern 6 gelagert.

Das Schwingungsisolationssystem umfasst eine aktive Regelung. Der Druck der Luftlager 6 wird über ein Ventil 5 gesteuert. Eine Pumpe 7 liefert den nötigen Druck.

Das Ventil wird über die Regeleinrichtung des Fluiddrucks, die erste Regeleinrichtung 3, gesteuert.

Zum Positionsausgleich weist das Schwingungsisolationssystem einen Positionssensor 1 auf, dessen Ausgangssignal an die zweite Regeleinrichtung 2 weitergegeben wird. Die zweite Regeleinrichtung 2 generiert ein Ausgangssignal und leitet dieses an zumindest einen Aktor 4, welcher Schwingungen aktiv entgegenwirkt. Gleichzeitig wird ein Ausgangssignal an die Regeleinrichtung des Fluiddrucks, die erste Regeleinrichtung 3, weiter geleitet. Die beiden Regeleinrichtungen 2 und 3 sind so kaskadiert geschaltet.

### Bezugszeichenliste

- 1: Positionssensor
- 2: zweite Regeleinrichtung
- 3: erste Regeleinrichtung
- 4: Aktor
- 5: Ventil
- 6: Luftlager
- 7: Pumpe
- 8: Platte

## Patentansprüche

1. Schwingungsisolationssystem, umfassend zumindest ein Fluidlager mit einer ersten Regeleinrichtung zur Steuerung des Fluiddrucks und zumindest einen Aktor zum Ausgleichen von Positionsänderungen der zu isolierenden Last, der von zumindest einer zweiten Regeleinrichtung gesteuert wird, wobei der Eingang der zweiten Regeleinrichtung mit zumindest einem Positionssensor der die Lage der zu isolierenden Last in zumindest einer Raumrichtung erfasst, verbunden ist,
**dadurch gekennzeichnet, dass**
der Eingang der ersten Regeleinrichtung mit dem Ausgang der zweiten Regeleinrichtung verbunden ist.

2. Schwingungsisolationssystem nach Anspruch 1, **dadurch gekennzeichnet, dass** der Eingang der zweiten Regeleinrichtung mit zumindest einem, Positionssensor der die Lage der zu isolierenden Last in zumindest einer Raumrichtung erfasst, verbunden ist.

3. Schwingungsisolationssystem nach einem der vorstehenden Ansprüche, **dadurch gekennzeichnet, dass** das Fluidlager als Luftlager ausgebildet ist.

4. Schwingungsisolationssystem nach einem der vorstehenden Ansprüche, **dadurch gekennzeichnet, dass** als Aktoren Magnet-Aktoren, insbesondere Tauchspulen mit Permanentmagnet, und/oder Piezo-Aktoren vorgesehen sind.

5. Schwingungsisolationssystem nach einem der vorstehenden Ansprüche, **dadurch gekennzeichnet, dass** die Regelbandbreite der ersten Regeleinrichtung unter 20 Hz, bevorzugt unter 10 Hz und besonders bevorzugt unter 5 Hz liegt.

6. Schwingungsisolationssystem nach einem der vorstehenden Ansprüche, **dadurch gekennzeichnet, dass** die Regelbandbreite der zweiten Regeleinrichtung Frequenzen über 50 Hz, bevorzugt über 100 Hz und besonders bevorzugt über 200 Hz umfasst.

7. Schwingungsisolationssystem nach einem der vorstehenden Ansprüche, **dadurch gekennzeichnet, dass** der Fluiddruck über zumindest ein elektropneumatisches Ventil gesteuert wird.

8. Schwingungsisolationssystem nach einem der vorstehenden Ansprüche, **dadurch gekennzeichnet, dass** erste und zweite Regeleinrichtung in einem Gerät, insbesondere einem Computer, kombiniert sind.

9. Verfahren zur Schwingungsisolation, bei welchem eine zu isolierende Last auf Fluidlagern gelagert und der Fluiddruck über zumindest eine erste Regeleinrichtung gesteuert wird, welche mit einem Sensor zur Positionserfassung der zu isolierenden Last verbunden ist, wobei zumindest ein Aktor über eine zweite Regeleinrichtung gesteuert wird,
**dadurch gekennzeichnet, dass**
das Ausgangssignal der zweiten Regeleinrichtung als Eingangssignal an die erste Regeleinrichtung weiter geleitet wird.

10. Verfahren zur Schwingungsisolation nach dem vorstehenden Anspruch, **dadurch gekennzeichnet, dass** der Fluiddruck mit einer geringeren Regelbandbreite gesteuert wird als der zumindest eine Aktor.

11. Verfahren zur Schwingungsisolation nach Anspruch 9 oder 10 **dadurch gekennzeichnet, dass** der Fluiddruck mit einer Regelbandbreite von unter 10 Hz, bevorzugt unter 5 Hz und der Aktor mit einer Regelbandbreite bis mehr als 50 Hz, bevorzugt bis mehr als 100 Hz betrieben wird.

## Claims

1. A vibration isolating system comprising at least one fluid bearing that includes a first control device for controlling the fluid pressure and at least one actuator for compensating positional changes of the load that is to be isolated, which actuator is controlled by at least a second control device, wherein the input of the second control device is connected to at least one position sensor which detects the position of the load to be isolated in at least one spatial direction,
**characterized in that**
the input of the first control device is connected to the output of the second control device.

2. The vibration isolating system according to claim 1, **characterized in that** the input of the second control device is connected to at least one position sensor which detects the position of the load to be isolated in at least one spatial direction.

3. The vibration isolating system according to any of the preceding claims, **characterized in that** said fluid bearing is provided in form of an air bearing.

4. The vibration isolating system according to any of the preceding claims, **characterized in that** said actuator(s) is/are in form of magnetic actuators, in particular dip coils having a permanent magnet, and/or piezo actuators.

5. The vibration isolating system according to any of the preceding claims, **characterized in that** the control bandwidth of the first control device is smaller than 20 Hz, preferably smaller than 10 Hz, and most preferably smaller than 5 Hz.

6. The vibration isolating system according to any of the preceding claims, **characterized in that** the control bandwidth of the second control device comprises frequencies above 50 Hz, preferably above 100 Hz, and most preferably above 200 Hz.

7. The vibration isolating system according to any of the preceding claims, **characterized in that** the fluid pressure is controlled via at least one electropneumatic valve.

8. The vibration isolating system according to any of the preceding claims, **characterized in that** said first and second control devices are combined in a single device, in particular a computer.

9. A method for vibration isolation in which a load to be isolated is carried on fluid bearings and fluid pressure is controlled via at least a first control device which is connected to a sensor for detecting the position of a load to be isolated, wherein at least one actuator is controlled via a second control device,
**characterized in that**
the signal output from said second control device is supplied as a signal input to said first control device.

10. The method for vibration isolation according to the preceding claim, **characterized in that** the fluid pressure is controlled with a smaller control bandwidth than that for the at least one actuator.

11. The method for vibration isolation according to claim 9 or 10, **characterized in that** the fluid pressure is operated with a control bandwidth smaller than 10 Hz, preferably smaller than 5 Hz; and that the actuator is operated with a control bandwidth up to more than 50 Hz, preferably up to more than 100 Hz.

## Revendications

1. Système d'isolation de vibrations, comprenant au moins un palier à fluide avec un premier dispositif de réglage pour la commande de la pression de fluide et au moins un actionneur pour l'équilibrage de variations de position de la charge à isoler, qui est commandée par au moins un second dispositif de réglage, l'entrée du second dispositif de réglage étant reliée à au moins un capteur de position qui enregistre la position d'une charge à isoler dans au moins une direction de l'espace,
**caractérisé en ce que**
l'entrée du premier dispositif de réglage est reliée à la sortie du second dispositif de réglage.

2. Système d'isolation de vibrations selon la revendication 1, **caractérisé en ce que** l'entrée du second dispositif de réglage est reliée à au moins un capteur de position qui enregistre la position de la charge à isoler dans au moins une direction de l'espace.

3. Système d'isolation de vibrations selon l'une quelconque des revendications précédentes, **caractérisé en ce que** le palier à fluide est conçu sous forme de palier à air.

4. Système d'isolation de vibrations selon l'une quelconque des revendications précédentes, **caractérisé en ce que** des actionneurs à aimant, en particulier des bobines mobiles avec aimant permanent et/ou des piézo-actionneurs sont prévus comme actionneurs.

5. Système d'isolation de vibrations selon l'une quelconque des revendications précédentes, **caractérisé en ce que** la largeur de bande de réglage du premier dispositif de réglage est inférieure à 20 Hz, de préférence inférieure à 10 Hz et avec une préférence particulière inférieure à 5 Hz.

6. Système d'isolation de vibrations selon l'une quelconque des revendications précédentes, **caractérisé en ce que** la largeur de bande de réglage du second dispositif de réglage comprend des fréquences supérieures à 50 Hz, de préférence supérieures à 100 Hz et avec une préférence particulière supérieures à 200 Hz.

7. Système d'isolation de vibrations selon l'une quelconque des revendications précédentes, **caractérisé en ce que** la pression du fluide est commandée au moyen d'au moins une vanne électropneumatique.

8. Système d'isolation de vibrations selon l'une quelconque des revendications précédentes, **caractérisé en ce que** le premier et le second dispositif de réglage sont combinés dans un appareil, en particulier un ordinateur.

9. Procédé pour l'isolation de vibration, avec lequel une charge à isoler est montée sur des paliers à fluide et la pression de fluide est commandée au moyen d'au moins un premier dispositif de réglage, qui est relié à un capteur pour l'enregistrement de position de la charge à isoler, au moins un actionneur étant commandé par un second dispositif de réglage,
**caractérisé en ce que**
le signal de sortie du second dispositif de réglage est transmis comme signal d'entrée au premier dispositif de réglage.

10. Procédé pour l'isolation de vibrations selon la revendication précédente, **caractérisé en ce que** la pression de fluide est commandée avec une largeur de bande de réglage plus faible que le au moins un actionneur.

11. Procédé pour l'isolation de vibrations selon la revendication 9 ou 10, **caractérisé en ce que** la pression de fluide est utilisée avec une largeur de bande de réglage inférieure à 10Hz, de préférence inférieure à 5Hz et l'actionneur avec une largeur de bande de réglage jusqu'à plus de 50 Hz, de préférence jusqu'à plus de 100 Hz.
